Europäisches Patentamt

European Patent Office

Office Européen des brevets

(11) Numéro de publication : **0 215 979 B1**

# (12) FASCICULE DE BREVET EUROPEEN

(45) Date de publication du fascicule du brevet :
02.01.91 Bulletin 91/01

(51) Int. Cl.⁵ : **G01R 31/34**

(21) Numéro de dépôt : 85201440.6

(22) Date de dépôt : 11.09.85

(54) **Procédé pour tester l'état de l'isolation d'une machine électrique.**

(43) Date de publication de la demande :
01.04.87 Bulletin 87/14

(45) Mention de la délivrance du brevet :
02.01.91 Bulletin 91/01

(84) Etats contractants désignés :
AT BE CH DE FR GB IT LI LU NL SE

(56) Documents cités :
EP-A- 0 038 790
IEE PROCEEDINGS, vol. 127, partie B, no. 3,
mai 1980, pages 139-154, Hitchin, Herts, GB;
J.S. SIMONS et al.: "Diagnostic tesing of
high-voltage machine insulation"
ELEKTRIE, vol. 26, no. 7, juillet 1972, page
U165, Berlin, DD; "Untersuchung von
Methoden zur zerstörungsfreien
Isolationsprüfung elektrischer Maschinen"

(73) Titulaire : ACEC ENERGIE S.A.
Rue Chapelle Beaussart 80
B-6030 Charleroi (BE)

(72) Inventeur : Goffaux, Raoul Alfred Alexandre
Félicien
Avenue Paul Pastur, 418
B-6100 Mont-Sur-Marchienne (BE)

(74) Mandataire : Bosch, Henry et al
Office VAN MALDEREN Boulevard de la
Sauvenière, 85/042
B-4000 Liège (BE)

## Description

Il est déjà connu de tester l'état de l'isolation d'une machine électrique en appliquant à travers une résistance une tension inférieure à celle apparaissant pendant le service entre deux parties conductrices de la machine, séparées par une isolation à tester, et de mesurer le courant de charge à des moments déterminés après l'instant d'application de la tension. Certaines de telles mesures font d'ailleurs l'objet de normes, notamment celles qui permettent de calculer une valeur connue sous le nom " indice de polarisation ".

L'inventeur a constaté que, dans certains cas, cet indice de polarisation peut présenter des valeurs acceptables et même bonnes, mais que l'isolation testée est, malgré cela, en mauvais état.

L'invention a pour but un procédé pour tester l'isolation d'une machine électrique d'une fiabilité extrèmement grande, tenant compte des divers composants qui contribuent à assurer la qualité d'une bonne isolation électrique. Elle a notamment comme but de contrôler la qualité du séchage et du nettoyage du bobinage des machines électriques et le diagnostic de l'état de vieillissement global de l'isolation du bobinage de machines électriques à haute tension.

Suivant l'invention le nouveau procédé pour tester l'isolation d'une machine électrique est caractérisé en ce qu'on prélève au moyen d'un dispositif échantillonneur des valeurs de mesure du courant de charge à un certain nombre de moments déterminés après l'instant de l'application de la tension, en ce qu'on transforme les valeurs échantillonnées en données numériques pour les mémoriser dans une unité de calcul, en ce qu'on calcule à partir des valeurs mesurées et échantillonnées de l'évolution du courant de charge trois constantes de temps en adoptant comme formule d'interpolation la relation :

$$ J(t) = I_1 \exp{-\frac{t}{\tau_1}} + I_2 \exp{-\frac{t}{\tau_2}} + I_3 \exp{-\frac{t}{\tau_3}} $$

dans laquelle $J(t)$ est le courant de charge mesuré, $t$, les moments de mesure, $I_1$ $I_2$ $I_3$ des paramètres à calculer et $\tau_1$ $\tau_2$ $\tau_3$ des constantes de temps à calculer et à afficher.

Il convient de noter que dans la relation ci-dessus les valeurs des constantes de temps $\tau_1$ $\tau_2$ $\tau_3$ sont très différentes l'une de l'autre, par exemple $\tau_2 = 3\tau_1$ ; $\tau_3 = 10\,\tau_1$, de sorte que l'interpolation suivant la formule ci-dessus est relativement facile. La formule ci-dessus n'est cependant utilisable que dans le cas où la contribution d'un courant de régime $I_R$ après l'atténuation des courants transitoires consécutifs à l'instant d'application de la tension est nul ou négligeable. Dans tous les autres cas, il est nécessaire de tenir compte de ce courant de régime $I_R$.

L'invention est expliquée ci-dessous à l'aide d'un exemple d'une forme d'exécution en se référant au dessin annexé. L'unique figure du dessin représente un schéma d'un appareil de mesure conçu pour exécuter le procédé suivant l'invention.

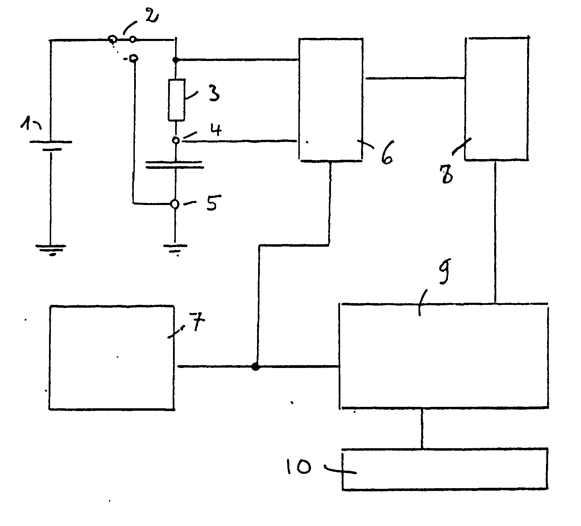

Suivant la figure 1, un appareil de mesure et de calcul comprend une source de tension continue 1 dont un des pôles est relié via un commutateur 2 et une résistance calibrée 3 à une borne de mesure 4. Une autre borne de mesure 5 est reliée à l'autre pôle de la source de tension continue, par exemple via la terre. Le commutateur 2 permet de court-circuiter la branche comprenant la résistance calibrée 3 et les électrodes de mesure 4 et 5. Une isolation à tester, par exemple l'isolation d'un stator d'une machine électrique forme le diélectrique d'un condensateur dont une des électrodes, par exemple le fil du bobinage, est reliée à la borne 4 et l'autre, en l'occurrence la masse, à la borne 5.

A partir de l'instant de l'application de la tension aux bornes de mesure, déterminée par l'actionnement du commutateur 2, un courant de charge circule à travers la résistance 3 dans les électrodes entourant l'isolation. Aux bornes de cette résistance 3 apparaît donc une tension de mesure proportionnelle à ce courant de charge. Cette tension de mesure est prélevée à un certain nombre de moments déterminés après l'instant d'application de la tension au moyen d'un dispositif échantillonneur 6 gouverné par une horloge 7. Les valeurs de mesure prélevées par le dispositif 6 sont transformées dans un convertisseur analogique-numérique 8 en données numériques et envoyées dans une unité de mémorisation et de calcul 9. Certains des résultats et paramètres du traitement de données effectué dans l'unité de mémorisation et de calcul 9 sont ensuite affichés dans un dispositif d'affichage 10 tel qu'un écran à rayon cathodique ou une imprimante.

Le dispositif échantillonneur 6 prélève par exemple une première valeur de mesure 10 secondes après l'instant d'application de la tension et ensuite à intervalles réguliers de 10 secondes jusqu'à 1 minute. Ensuite, les intervalles de prélèvement peuvent changer et comprendre une série géométrique, par exemple 1,2,4,8 minutes ou suivre une autre série arithmétique, par exemple 1,2,3...9, 10 minutes. De toute manière, il est avantageux, comme cela sera expliqué ci-dessous, de pouvoir disposer d'une ou plusieurs séries géométriques d'au moins trois nombres, relativement éloignés de l'instant d'application de la tension, par exemple 2,4,8 minutes. Rien n'empêche de prévoir des moments intermédiaires dans une série arithmétique, par exemple 6,25 min et 7,5 min, pour engendrer ainsi la série géométrique : 6,25 ; 7,5 ; 9 min. La durée totale de 10 min au moins de la série de mesures est choisie de préférence en raison de l'existence de normes pour la détermination de l'indice de polarisation calculé suivant les normes à partir de mesures du courant de charge à une et à 10 min après l'application de la tension. Cet indice peut être déterminé automatiquement au moyen de l'appareil de mesure et de calcul utilisé pour le procédé suivant l'invention.

Comme déjà dit, l'indice de polarisation s'est révélé être une grandeur peu fiable pour l'interprétation de l'état d'une isolation d'une machine électrique. Le procédé suivant l'invention permet de compléter ou même de remplacer l'indice de polarisation pour l'interprétation de l'état d'une isolation par l'appréciation notamment et principalement de trois constantes de temps $\tau_1$, $\tau_2$, $\tau_3$ qui permettent de tenir compte totalement de l'allure de l'évolution du courant de charge dans le temps consécutif à l'application de la tension. La détermination de ces constantes de temps dans une unité de calcul informatisée peut se faire en temps réel et ne présente donc aucune difficulté technique.

Les études de l'inventeur ont permis de trouver une formule d'interpolation pour l'évolution du courant de charge dont les paramètres, à déterminer en fonction des valeurs de mesure enregistrées, possèdent des significations particulièrement parlantes du point de vue des phénomènes physiques globaux qui se manifestent lors de l'encrassage et du vieillissement d'une isolation d'une machine électrique. Cette formule d'interpolation est représentée par la relation suivante : ($J_c$ (t) étant l'évolution du courant de charge pendant la période totale de mesure dans l'appareil décrit) :

$$J_c(t) = I_R + At^{-n} + I_1 \exp{-\frac{t}{\tau_1}} + I_2 \exp{-\frac{t}{\tau_2}} + I_3 \exp{-\frac{t}{\tau_3}}$$

Dans cette relation, $I_R$ est une valeur constante d'un courant qui s'établit après l'atténuation des courants transitoires consécutifs à l'application de la tension. $I_1$, $I_2$, $I_3$ sont des paramètres à calculer dont l'importance pour l'interprétation de l'état de l'isolation est relativement faible, $\tau_1$, $\tau_2$, $\tau_3$ sont des constantes de temps dont la signification sera expliquée ci-dessous et $At^{-n}$ est un terme qui doit être pris en considération détaillée seulement pour des machines dont les développantes sont recouvertes d'un vernis anti-effluves c'est-à-dire en général pour des machines dont la tension de service est au dessus d'au moins 6 kV. L'identification de ce terme est facilité par le fait que suivant des considérations théoriques l'exposant n vaut 1/2 et que l'expérience le confirme.

Pour des machines dont les développantes ne sont pas enduites d'un vernis anti-effluves, le terme $At^{-n}$ est un terme inexistant, si l'isolation est neuve et en bon état. Même si l'on constate l'apparition de ce terme $At^{-n}$ dans une isolation d'une machine à faible tension de service, il disparaît généralement après un nettoyage approfondi, par exemple au jet d'eau et un séchage prolongé, complet, consécutif. Si ce terme ne disparaît pas après cette opération, il faut conclure à une défectuosité dangereuse de l'isolation et recommander le rebobinage de la machine ou au moins procéder à une réparation locale.

Il existe également des isolations dans lesquelles le terme $I_R$ est négligeable. Toutefois, les valeurs admissibles du terme $I_R$ sont réglées par des normes et peuvent être suffisamment importantes pour nécessiter leur prise en considération dans la formule d'interpolation ci-dessus.

Il existe donc des cas particuliers, simples dans lesquels les termes $I_R$ et $At^{-n}$ peuvent être négligés et dans lesquels la formule d'interpolation est représentée par la relation

$$J_c(t) = I_1 \exp{-\frac{t}{\tau_1}} + I_2 \exp{-\frac{t}{\tau_2}} + I_3 \exp{-\frac{t}{\tau_3}}$$

D'autre part, il résulte de calculs théoriques, vérifiés expérimentalement que dans le cas où le terme $At^{-n}$ est nul ou négligeable, il est possible de calculer $I_R$ au moyen de la formule suivante :

$$I_R = \frac{J(t_1)\,J(t_3) - J^2(t_2)}{J(t_1) + J(t_3) - 2\,J(t_2)}$$

Dans cette formule, $J(t_1), J(t_2), J(t_3)$ sont les valeurs de courants de charge mesurées pour trois moments $t_1, t_2, t_3$ formant des membres d'une série arithmétique $t_1, t_2 = a+t_1, t_3 = 2a+t_1$ par exemple 6,8, 10 min ou 8,9, 10 min. Il est nécessaire en outre que $t_1$ soit plus grand que $\tau_2$. Il est possible de supposer à priori que toutes ces conditions sont remplies et de calculer la valeur $I_R$ pour deux séries arithmétiques différentes de moments $t_1\ t_2\ t_3$.

Si les résultats sont concordants et répondent en outre à d'éventuels autres critères, la supposition est vérifiée et la formule d'interpolation simplifiée ci-dessus peut être appliquée à la grandeur $J_C(t) - I_R$ dans laquelle $I_R$ est la valeur moyenne des calculs à l'aide des deux séries arithmétiques différentes de moments de mesure.

Ces calculs de $I_R$ sont avantageux, car ils peuvent être effectués avec une très grande rapidité et permettent d'examiner la nécessité de procéder à d'autres mesures. Cette nécessité est évidente, si les valeurs de $I_R$ ne concordent pas, ou si elles sont manifestement erronées, par exemple négatives. D'autres contrôles peuvent évidemment être envisagées en supplément.

Les autres mesures à envisager consistent à relever l'évolution du courant de décharge $J_D(t)$ juste après avoir relevé l'évolution du courant de charge $J_C(t)$ comme décrit ci-dessus. A ce moment, l'isolation à tester a donc été soumise à une tension pendant tout le temps nécessaire à l'exécution des mesures de l'évolution du courant de charge. Pour mesurer l'évolution du courant de décharge, la branche de mesure comprenant la résistance 3 et les bornes de mesure 4 et 5 ou ce qui revient au même, l'isolation à tester est court-circuitée au moyen du commutateur 2. Ensuite, on échantillonne les valeurs de mesure apparaissant à un certain nombre de moments de mesure après l'instant de court-circuitage. On obtient ainsi l'évolution d'un courant de décharge $J_D(t)$ qui suit la même loi que le courant de charge mais d'office ne comprend pas de composant $I_R$. La constante $I_R$ apparaît alors, mesurée avec précision, en faisant la différences des mesures $J_C(t) - J_D(t)$ point par point pour un certain nombre de moments $t$. Mais, comme dit ci-dessus, cette deuxième série de mesures peut être évitée dans beaucoup de cas, grâce à l'application de la formule pour $I_R$.

Si la différence $J_C(t) - J_D(t)$ ne fournit pas une constante, l'hypothèse que le terme $At^{-n}$ est négligeable est erronée. Même dans un tel cas, la relation ci-dessus pour $I_R$ peut encore être appliquée lorsque les conditions suivantes sont remplies : les moments $t_1$, $t_2$, $t_3$ sont tous sensiblement plus grands que $\tau_3$ et sont distribués suivant une série géométrique, par exemple 6,25 min, 7,5 min, 9 min, tandis que pour ces moments $t_1$, $t_2$, $t_3$, la contribution des termes exponentiels est négligeable. Dans ce dernier cas, la formule d'interpolation générale

$$J_C(t) - I_R = At^{-n} + I_1 \exp{-\frac{t}{\tau_1}} + I_2 \exp{-\frac{t}{\tau_2}} + I_3 \exp{-\frac{t}{\tau_3}}$$

se réduit à : $J_C(t) - I_R = At^{-n}$.

$At^{-n}$ peut donc être déterminé à partir des valeurs asymptotiques pour $t$ très grand. Dans la détermination des valeurs asymptotiques, l'identification de la contribution du terme $At^{-n}$ est facilitée par le fait qu'on peut poser $n = 1/2$. Après soustraction du résultat pour $At^{-n}$, la relation simplifiée de la formule d'interpolation apparaît :

$$J_C(t) - I_R - At^{-n} = I_1 \exp{-\frac{t}{\tau_1}} + I_2 \exp{-\frac{t}{\tau_2}} + I_3 \exp{-\frac{t}{\tau_3}}$$

Comme déjà dit, l'application de cette formule d'interpolation est relativement simple puisque les constantes de temps $\tau_1$, $\tau_2$, $\tau_3$ sont très différentes.

Si aucune des hypothèses précédentes ne se vérifie, l'interpolation de la formule générale doit être entreprise soit par un calcul analytique très compliqué nécessitant au moins quatre mesure différentes du courant de charge pour quatre moments $t_1$, $t_2$, $t_3$, $t_4$, distribués de préférence suivant une série arithmétique et dans laquelle tous les moments $t_1$ à $t_4$ sont considérablement plus grands que $\tau_2$ par exemple plus grands que $3\ \tau_2$. Il est possible aussi, mais non moins compliqué, de procéder par des iterations et corrections successives et d'établir ainsi la correspondance entre valeurs mesurées et les paramètres de la formule d'interpolation.

Les constantes de temps $\tau_1$, $\tau_2$, $\tau_3$ forment un ensemble essentiel pour l'interprétation de l'état de l'isolation et ne peuvent en aucun cas être remplacées par une constante de temps moyenne unique résultant d'une interpolation plus grossière de l'évolution du courant de charge.

En effet, il est apparu que la constante de temps $\tau_1$ est une grandeur représentative du temps de formation de charges d'espace à l'intérieur des composants de l'isolation qui préparent la dégradation des propriétés diélectriques. Ce temps $\tau_1$ ne peut pas être inférieur à une limite qui dépend de la nature de l'isolation et de la fréquence de la tension de service du moteur, mais qui est de l'ordre de grandeur d'une ou plusieurs dizaines de secondes.

D'autre part, la constante de temps $\tau_2$ est une grandeur représentative du temps de mise en équilibre des porteurs de charge dans le champ électrique appliqué, elle dépend aussi de la nature de l'isolant et des conditions de service de la machine et doit dépasser une limite dont l'ordre de gandeur est dans les environs de 100 S.

Finalement, la constante de temps $\tau_3$ est une grandeur représentative du temps d'accumulation de charges sur la surface de séparation entre composantes différentes de l'isolation, elle dépend, outre de la nature des composants de l'isolation, de la capacité du bobinage et doit dépasser, dans le cas de moteurs d'une puissance au dessus de 100 kVA, une limite dont l'ordre de grandeur est dans les environs de 300 S.

Il apparaît donc, comme déjà observé plus haut, que les trois constantes de temps sont très différentes l'une de l'autre et que de ce fait la décomposition de la formule d'interpolation est assez facile étant donné que pour des durées de plusieurs minutes après l'application de la tension, seul le dernier terme $I_3 \exp\frac{t}{t_3}$ apporte une contribution sensible à la valeur $J(t) - I_R - At^{-n}$. Les deux autres termes peuvent alors être négligés. Après la soustraction du terme $I_3 \exp\frac{-t}{t_3}$ il est possible ensuite de déterminer le terme $I_2 \exp\frac{-t}{t_2}$ et après soustraction de ce deuxième terme il subsiste seul le premier terme $I_1 \exp\frac{-t}{t_1}$ qui peut être déterminé facilement.

Le fait d'utiliser comme unité de calcul un ordinateur de taille appropriée ou une liaison avec un ordinateur de grande taille permet d'exécuter les calculs nécessaires en temps réel et d'évaluer sans retard la nécessité de procéder ou non à l'exécution de la série de mesures du courant de décharge.

L'utilisation d'une unité de calcul 9 permet également de remplacer chaque mesure du courant de charge ou du courant de décharge par une salve de plusieurs mesures. Les différentes mesures d'une salve peuvent alors être effectuées dans une fraction de seconde. Par exemple, chaque mesure de la salve peut être séparée de la suivante ou précédente d'un ordre de grandeur d'un dizième de seconde. Parmi les différentes mesures d'une salve, l'unité de calcul peut éliminer d'office une valeur erratique et adopter la moyenne des valeurs acceptées.

En résumé, le procédé suivant l'invention peut être utilisé comme un moyen d'apprécier l'état de vieillissement de l'isolation de machines électriques, comme moyen de contrôle de l'efficacité du nettoyage et séchage de l'isolation du bobinage, et comme moyen de détection et de l'appréciation de l'importance de la pollution des développantes.

## Revendications

1. Procédé pour tester l'état de l'isolation d'une machine électrique dans lequel on applique, à travers une résistance, une tension inférieure à celle apparaissant pendant le service entre deux parties conductrices de la machine séparées par une isolation à tester, et dans lequel on mesure le courant de charge traversant la résistance à des moments déterminés après l'instant de l'application de la tension, caractérisé en ce qu'on prélève au moyen d'un dispositif échantillonneur des valeurs de mesure du courant de charge à un certain nombre de moments déterminés après l'instant de l'application de la tension, en ce qu'on transforme les valeurs échantillonnées en données numériques pour les mémoriser dans une unité de calcul et en ce qu'on calcule à partir des valeurs mesurées et échantillonnées de l'évolution du courant de charge trois constantes de temps en adoptant comme formule d'interpolation la relation :

$$J_c(t) = I_1 \exp -\frac{t}{\tau_1} + I_2 \exp -\frac{t}{\tau_2} + I_3 \exp -\frac{t}{\tau_3}$$

dans laquelle $J_c(t)$ est le courant de charge mesuré, $t$, les moments de mesure, $I_1, I_2, I_3$ des paramètres à calculer et $\tau_1, \tau_2, \tau_3$ des constantes de temps à calculer et à afficher.

2. Procédé suivant la revendication 1,

caractérisé en ce qu'on calcule à partir des valeurs échantillonnées de l'évolution du courant de charge une valeur $I_R$ d'un courant s'établissant après l'atténuation des courants transitoires consécutifs à l'instant de l'application de la tension en adoptant comme formule de calcul la relation :

$$I_R = \frac{J(t_1)\,J(t_3) - J^2(t_2)}{J(t_1) + J(t_3) - 2\,J(t_2)}$$

dans laquelle $J(t_1)$, $J(t_2)$, $J(t_3)$ sont des mesures du courant de charge pour des moments $t_1$, $t_2 = a + t_1$, $t_3 = 2a + t_1$, $t_1$ étant considérablement plus grand que $\tau_2$ et en ce qu'on adopte comme formule d'interpolation pour l'évolution du courant de charge la relation :

$$J_C(t) - I_R = I_1 \exp{-\frac{t}{\tau_1}} + I_2 \exp{-\frac{t}{\tau_2}} + I_3 \exp{-\frac{t}{\tau_3}}$$

3. Procédé suivant la revendication 1,
caractérisé en ce qu'après la mesure de l'évolution du courant de charge, on met en court-circuit la branche de mesure comprenant la résistance et l'isolation à tester, en ce qu'on prélève au moyen du dispositif échantillonneur des valeurs de mesure d'un courant de décharge $J_D(t)$ prises à un certain nombre de moments déterminés après l'instant de mise en court-circuit de la branche de mesure, en ce que pour un certain nombre de moments déterminés, on calcule la différence $J_C(t) - J_D(t)$ entre d'une part, le courant de charge mesuré à un moment choisi après l'instant d'application de la tension, et d'autre part, le courant de décharge mesuré au même moment après la mise en court-circuit de la branche de mesure, en ce qu'on vérifie que cette différence tend vers une valeur constante $I_R$ et en ce qu'on adopte comme formule d'interpolation pour l'évolution du courant de charge la relation :

$$J_D(t) = J_C(t) - I_R = I_1 \exp{-\frac{t}{\tau_1}} + I_2 \exp{-\frac{t}{\tau_2}} + I_3 \exp{-\frac{t}{\tau_3}}$$

en ce qu'on calcule $I_1$, $I_2$, $I_3$, $\tau_1$, $\tau_2$, $\tau_3$, et en ce qu'on affiche $\tau_1$, $\tau_2$, $\tau_3$.
4. Procédé suivant la revendication 1,
caractérisé en ce qu'on adopte comme formule d'interpolation, la relation :

$$J_C(t) = I_R + A t^{-n} + I_1 \exp{-\frac{t}{\tau_1}} + I_2 \exp{-\frac{t}{\tau_2}} + I_3 \exp{-\frac{t}{\tau_3}}$$

en ce qu'on calcule les paramètres $A$, $n$, $I_1$, $I_2$, $I_3$, $\tau_1$, $\tau_2$, $\tau_3$, et en ce qu'on affiche $A$, $n$, $\tau_1$, $\tau_2$, $\tau_3$.
5. Procédé suivant la revendication 4,
caractérisé en ce qu'on calcule à partir des valeurs échantillonnées de l'évolution du courant de charge une valeur $I_R$ d'un courant s'établissant après l'atténuation des courants transitoires consécutifs à l'instant de l'application de la tension en adoptant comme formule de calcul la relation :

$$I_R = \frac{J(t_1)\,J(t_3) - J^2(t_2)}{J(t_1) + J(t_3) - 2\,J(t_2)}$$

dans laquelle $J(t_1)$, $J(t_2)$, $J(t_3)$ sont des mesures du courant de charge pour des moments $t_1$, $t_2 = a t_1$, $t_3 = a^2 t_1$, $t_1$ étant considérablement plus grand que $\tau_3$ et $a$ étant un paramètre laissé au choix de l'opérateur, et en ce qu'on adopte pour $A t^n$, la valeur asymptotique pour $t$ considérablement plus grand que $\tau_3$ de la relation: $J_C(t) - I_R = A t^{-n}$
6. Procédé suivant les revendications 4 ou 5,
caractérisé en ce que pour le calcul du terme $A t^{-n}$, on pose $n = 1/2$.

6

7. Procédé suivant la revendication 2,
caractérisé en ce qu'en cas de valeur erratique pour $I_R$ pour une isolation non recouverte d'un vernis anti-effluves, on interrompt les mesures et procédé à un nettoyage et séchage de la machine et en ce qu'on recommence ensuite les mesures.

8. Procédé suivant une des revendications précédentes,
caractérisé en ce que chaque prélèvement de mesure est constitué par une salve de plusieurs mesures dont on élimine les valeurs manifestement erratiques et dont on retient la moyenne des valeurs acceptées.

9. Procédé suivant une des revendications précédentes,
caractérisé en ce que les moments de mesure du courant de charge à compter de l'instant de l'application de la tension ou les moments de mesure du courant de décharge à compter de l'instant de la mise à la terre sont choisis pour fournir à la fois une série de mesure dans laquelle ces moments suivent une progression arithmétique et une série de mesure dans laquelle ces moments suivent une progression géométrique.

10. Procédé suivant une des revendications précédentes,
caractérisé en ce que les moments de prélèvement de mesure s'échelonnent entre une ou quelques secondes et au moins 10 minutes.

## Claims

1. Method for testing the condition of the insulation of an electrical machine in which method a voltage, less than that appearing during operation, is applied, through a resistor, between two conducting parts of the machine, separated by an insulation to be tested, and in which method the charging current crossing the resistor is measured at specified times after the instant of the application of the voltage, characterized in that, by means of a sampling device, measurement values of the charging current are recorded at a certain number of specified times after the instant of the application of the voltage, in that the sampled values are transformed into digital data in order to store them in a calculation unit and, in that from the measured and sampled values of the evolution of the charging current, three time constants are calculated by adopting, as interpolation formula, the relationship :

$$J_c(t) = I_1 \exp -\frac{t}{\tau_1} + I_2 \exp -\frac{t}{\tau_2} + I_3 \exp -\frac{t}{\tau_3}$$

in which Jc(t) is the measured charging current, t the measurement times, $I_1$, $I_2$ and $I_3$ parameters to be calculated, and $\tau_1$, $\tau_2$ and $\tau_3$ time constants to be calculated and to be displayed.

2. Method according to Claim 1, characterized in that from sampled values of the evolution of the charging current a value $I_R$ is calculated of a current which is established after the attenuation of the transient currents following the instant of the application of the voltage, by adopting as calculation formula the relationship :

$$I_R = \frac{J(t_1) \; J(t_3) - J^2(t_2)}{J(t_1) + J(t_3) - 2J(t_2)}$$

in which J ($t_1$), J ($t_2$) and J ($t_3$) are measurements of the charging current for times $t_1$, $t_2 = a + t_1$, $t_3 = 2a + t_1$, $t_1$ being considerably larger than $\tau_2$ and in that the relationship

$$J_c(t) - I_R = I_1 \exp -\frac{t}{\tau_1} + I_2 \exp -\frac{t}{\tau_2} + I_3 \exp -\frac{t}{\tau_3}$$

is adopted as interpolation formula for the evolution of the charging current.

3. Method according to Claim 1, characterized in that after the measurement of the evolution of the charging current, the measuring branch containing the resistor and the insulation to be tested is shortcircuited, in that by means of the sampling device, measurement values of a discharging current $J_D(t)$, taken at a certain number of specified times after the instant of short-circuiting of the measuring branch, are recorded, in that for a certain number of specified times the difference $J_c(t) - J_D(t)$ between on the one hand, the charging current measured at a chosen time after the instant of application of the voltage, and on the other hand, the discharging current measured at the same time after the short-circuiting of the measuring branch is calculated, in that it is verified that this difference tends towards a constant value $I_R$ and in that the relationship

$$J_D(t) = J_c(t) \quad I_R = + I_1 \exp - \frac{t}{\tau_1} + I_2 \exp - \frac{t}{\tau_2} + I_3 \exp - \frac{t}{\tau_3}$$

is adopted as interpolation formula for the evolution of the charging current, in that $I_1$, $I_2$, $I_3$, $\tau_1$, $\tau_2$ and $\tau_3$ are calculated, and in that $\tau_1$, $\tau_2$ and $\tau_3$ are displayed.

4. Method according to Claim 1, characterized in that the relationship

$$J_c(t) - I_R = At^{-n} + I_1 \exp - \frac{t}{\tau_1} + I_2 \exp - \frac{t}{\tau_2} + I_3 \exp - \frac{t}{\tau_3}$$

is adopted as interpolation formula, in that the parameters A, n, $I_1$, $I_2$, $I_3$, $\tau_1$, $\tau_2$ and $\tau_3$ are calculated, and in that A, n, $\tau_1$, $\tau_2$ and $\tau_3$ are displayed.

5. Method according to Claim 4, characterized in that from sampled values of the evolution of the charging current a value $I_R$ is calculated of a current which is established after the attenuation of the transient currents following the instant of the application of the voltage, by adopting as calculation formula the relationship :

$$I_R = \frac{J(t_1) \, J(t_3) - J^2(t_2)}{J(t_1) + J(t_3) - 2J(t_2)}$$

in which $J(t_1)$, $J(t_2)$ and $J(t_3)$ are measurements of the charging current for times $t_1$, $t_2 = at_1$, $t_3 = a^2t1$, t1 being considerably larger than $\tau_3$ and a being a parameter left to the choice of the operator, and in that the asymptotic value of the relationship

$$J_c(t) - I_R = At^{-n}$$

for t considerably larger than $\tau_3$, is adopted for $At^{-n}$.

6. Method according to Claims 4 or 5, characterized in that for the calculation of the term $At^{-n}$, n is put equal to 1/2.

7. Method according to Claim 2, characterized in that in the case of an erratic value for $I_R$ for an in, sulation not covered with a corona,shielding varnish, the measurements are interrupted and a cleaning and drying of the machine is proceeded to, and in that the measurements are then restarted.

8. Method according to one of the preceding claims, characterized in that each measurement recording is constituted by a burst of several measurements from which the obviously erratic values are eliminated and from which the mean of the accepted values is retained.

9. Method according to one of the preceding claims, characterized in that the measurement times of the charging current to be reckoned from the instant of the application of the voltage, or the measurement times of the discharging current to be reckoned from the instant of earthing, are chosen in order to furnish at one and the same time a series of measurements in which these times follow an arithmetic progression and a series of measurements in which these times follow a geometric progression.

10. Method according to one of the preceding claims, characterized in that the measurement recording times are spread between one or several seconds and at least 10 minutes.

**Ansprüche**

1. Verfahren zum Prüfen des Isolationszustandes einer elektrischen Maschine, bei dem über einen Widerstand eine Spannung angelegt wird, die niedriger ist als die Spannung, die während des Betriebs zwischen zwei leitenden Teilen der Maschine auftritt, die durch eine zu prüfende Isolation getrennt sind, und bei dem der Ladestrom gemessen wird, der zu bestimmten Zeitpunkten nach dem Anlegen der Spannung durch den Widerstand fließt, **dadurch gekennzeichnet, daß** mittels einer Probeentnahme-Vorrichtung Meßwerte des Ladestroms zu verschiedenen Zeitpunkten nach dem Anlegen der Spannung entnommen werden, **daß** die entnommenen Werte in numerische Daten umgewandelt werden, um sie in einer Recheneinheit zu speichern, **und daß** aufgrund der gemessenen und entnommenen Werte des Ladestromverlaufs drei Zeitkonstanten berechnet werden, wozu als Interpolationsformel die Beziehung :

$$J_C(t) = I_1 \exp{-\frac{t}{\tau_1}} + I_2 \exp{-\frac{t}{\tau_2}} + I_3 \exp{-\frac{t}{\tau_3}}$$

gewählt wird, bei der $J_C(t)$ der gemessene Ladestrom, t die Meßzeitpunkte, $I_1$, $I_2$, $I_3$ zu berechnende Parameter, und $\tau_1$, $\tau_2$, $\tau_3$ zu berechnende und anzuzeigende Zeitkonstanten sind.

2. Verfahren gemäß Anspruch 1, **dadurch gekennzeichnet, daß** aufgrund der entnommenen Werte des Ladestromverlaufs ein Wert $I_R$ eines Stromes berechnet wird, der nach Abklingen der Einschwingströme beim Anlegen der Spannung erhalten wird, wozu als Berechnungsformel die Beziehung :

$$I_R = \frac{J(t_1)\, J(t_3) - J^2(t_2)}{J(t_1) + J(t_3) - 2J(t_2)}$$

gewählt wird, bei der $J(t_1)$, $J(t_2)$, $J(t_3)$ Meßwerte des Ladestroms für Zeitpunkte $t_1$, $t_2 = a + t_1$, $t_3 = 2a + t_1$ sind, wobei $t_1$ wesentlich größer als $\tau_2$ ist, **und daß** als Interpolationsformel für den Ladestromverlauf die Beziehung :

$$J_C(t) - I_R = I_1 \exp{-\frac{t}{\tau_1}} + I_2 \exp{-\frac{t}{\tau_2}} + I_3 \exp{-\frac{t}{\tau_3}}$$

gewählt wird.

3. Verfahren gemäß Anspruch 1, **dadurch gekennzeichnet, daß** nach Messung des Ladestromverlaufs der Meßzweig aus dem Widerstand und der zu prüfenden Isolation kurzgeschlossen wird, **daß** mittels der Probeentnahme-Vorrichtung Meßwerte eines Entladestroms $J_D(t)$ zu verschiedenen, bestimmten Zeitpunkten nach dem Kurzschließen des Meßzweigs entnommen werden, **daß** für eine gewisse Anzahl von bestimmten Zeitpunkten die Differenz $J_C(t) - J_D(t)$ berechnet wird zwischen einerseits dem Ladestrom, der zu einem gewählten Zeitpunkt nach dem Anlegen der Spannung gemessen wird, und andererseits dem Entladestrom, der zu dem gleichen Zeitpunkt nach dem Kurzschließen des Meßzweigs gemessen wird, **daß** überprüft wird, ob diese Differenz nach einem konstanten Wert $I_R$ strebt, **daß** als Interpolationsformel für den Ladestromverlauf die Beziehung :

$$J_D(t) = J_C(t) - I_R = I_1 \exp{-\frac{t}{\tau_1}} + I_2 \exp{-\frac{t}{\tau_2}} + I_3 \exp{-\frac{t}{\tau_3}}$$

gewählt wird, **daß** $I_1$, $I_2$, $I_3$,$\tau_1$, $\tau_2$, $\tau_3$ berechnet werden, **und daß** $\tau_1$, $\tau_2$, $\tau_3$ angezeigt werden.

4. Verfahren gemäß Anspruch 1, **dadurch gekennzeichnet, daß** als Interpolationsformel die Beziehung :

$$J_C(t) = I_R + At^{-n} + I_1 exp- \frac{t}{\tau_1} + I_2 exp- \frac{t}{\tau_2} + I_3 exp- \frac{t}{\tau_3}$$

gewählt wird, daß die Parameter A, n, $I_1$, $I_2$, $I_3$, $\tau_1$, $\tau_2$, $\tau_3$ berechnet werden, und daß A, n, $\tau_1$, $\tau_2$, $\tau_3$ angezeigt werden.

5. Verfahren gemäß Anspruch 4, dadurch gekennzeichnet, daß aufgrund der entnommenen Werte des Ladestromverlaufs ein Wert $I_R$ eines Stroms berechnet wird, der nach Abklingen der Einschaltströme beim Anlegen der Spannung erhalten wird, wozu als Berechnungsformel die Beziehung :

$$I_R = \frac{J(t_1) \ J(t_3) - J^2(t_2)}{J(t_1) + J(t_3) - 2J(t_2)}$$

gewählt wird, bei der $J(t_1)$, $J(t_2)$, $J(t_3)$ Meßwerte des Ladestroms für Zeitpunkte $t_1$, $t_2 = at_1$, $t_3 = a^2t_1$ sind, wobei $t_1$ wesentlich größer als $\tau_3$ ist, und a ein Parameter ist, dessen Wahl dem Prüfer überlassen ist, und daß für $At^{-n}$ der asymptotische Wert für t wesentlich größer als $\tau_3$ aus der Beziehung :
$J_C(t) - I_R = At^{-n}$ gewählt wird.

6. Verfahren gemäß Anspruch 4 oder 5, dadurch gekennzeichnet, daß für die Berechnung des Ausdrucks $At^{-n}$ n = 1/2 gesetzt wird.

7. Verfahren gemäß Anspruch 2, dadurch gekennzeichnet, daß im Falle eines erratischen Wertes für $I_R$ bei einer nicht mit einem Sprühentladungs-Schutzlack überzogenen Isolation die Messungen abgebrochen werden und eine Reinigung und Trocknung der Maschine vorgenommen wird, und daß danach mit den Messungen noch einmal von vorne begonnen wird.

8. Verfahren gemäß einem der vorhergehenden Ansprüche, dadurch gekennzeichnet, daß jede Meßwertentnahme aus einer Meßwertserie besteht, bei der die offensichtlich erratischen Werte eliminiert werden und der Mittelwert der akzeptierten Werte zurückbehalten wird.

9. Verfahren gemäß einem der vorhergehenden Ansprüche, dadurch gekennzeichnet, daß die Zeitpunkte der Messung des Ladestroms ab dem Anlegen der Spannung, oder die Zeitpunkte der Messung des Entladestroms ab der Erdung so gewählt werden, daß eine Meßwert-Reihe, bei der diese Zeitpunkte einer arithmetischen Folge entsprechen, und zugleich eine Meßwert-Reihe, bei der diese Werte einer geometrischen Folge entsprechen, erhalten wird.

10. Verfahren gemäß einem der vorhergehenden Ansprüche, dadurch gekennzeichnet, daß die Zeitpunkte der Meßwert-Entnahme zwischen einer Sekunde oder einigen Sekunden und mindestens 10 Minuten liegen.